# EUROPEAN PATENT APPLICATION

(11) **EP 2 587 176 A2**
(43) Date of publication of application: **01.05.2013**
(21) Application number: 12181202.8
(22) Date of filing: 21.08.2012
(51) Int. Cl.: F24F 11/00

(54) **Air-side free cooling system and data center**

(30) Priority: 25.10.2011 JP 2011234354
(71) Applicant: Hitachi Ltd., Tokyo 100-8280 (JP)
(72) Inventor: Fujimoto, Takayuki, Tokyo, 100-8220 (JP); Kondo, Yoshihiro, Tokyo, 100-8220 (JP)
(74) Representative: Beetz & Partner

(57) **Abstract**

From a plurality of preset operation modes, an optimal mode is selected to let the supply air 206 attain a predetermined temperature and humidity. Upon adjusting the opening degrees of dampers 116 - 119, a cold water valve 156 and a humidifying water valve 154, the system measures the outside air 201, supply air 206 and return air 207 for temperature and humidity to see if a mode boundary is exceeded. If the boundary is exceeded, an assessment time is set. The humidity of the supply air 206 in the mode in effect before the boundary is exceeded is further predicted so as to determine whether the predicted value exceeds the upper limit of a tolerable humidity range or drops below the lower limit thereof. If the limit is exceeded, the operation mode is changed immediately. If the mode in effect before the boundary is exceeded is never resumed upon elapse of the assessment time, the mode is changed. If the mode in effect before the boundary is exceeded is resumed at least once, the mode is not changed. This make it possible to provide an air-side free cooling system which, if outside humidity abruptly changes, controls an air handling unit to prevent the humidity of supply air into the interior from suddenly fluctuating so as to optimize the indoor environment.

## Description

### BACKGROUND OF THE INVENTION

### 1. Field of the Invention

The present invention relates to an air-side free cooling system that utilizes outside air in winter and intermediate periods (spring and fall) and to a data center equipped with such an air-side free cooling system. More particularly, the invention relates to an air-side free cooling system for use in environments subject to high heat generation loads such as data centers requiring air conditioning throughout the year, and a data center furnished with such an air-side free cooling system.

### 2. Description of the Related Art

Amid growing interest in the issue of global warming, how to save electric power in information and telecommunication fields using "green" information technology (IT) is an urgent challenge. In particular, in cloud computing that processes exponentially increasing information flexibly using abundant computing resources, it is vital for the efficient running of cloud computing facilities to unify and virtualize IT platforms for consolidation and large-scale integration. Against that background, the demand has been rapidly increasing worldwide for data centers that constitute the basis of the IT platforms. Hence the challenge of managing growing power consumption by all such data centers.

In Japan, the average breakdown of power consumption at data centers is approximately 49% by IT equipment, 29% by air conditioning systems, 15% by power feeding systems, and 7% by others (ancillary facilities including lighting). Facilities and appliances (air conditioning and power feeding systems) can be seen consuming as much electric power as the IT equipment. It is thus desired to save electric power consumption by air conditioning systems that consume up to 30% of all electric power used up by the data center.

Because the data centers are air conditioned throughout the year, recent years have witnessed growing interest in the efforts to economize on air conditioning power for using air-side free cooling systems. This type of cooling system involves introducing outside air directly into the server room for air conditioning purposes in winter and intermediate periods (spring and fall) when outside temperature is relatively low.

Air conditioning systems utilizing such air-side free cooling systems are proposed in JP-2003-148782-A and JP-2010-261696-A, for example.

JP-2003-148782-A discloses an air-side free cooling system that sets the temperature and absolute humidity of supply air from outside-air cooling based on the temperature and absolute humidity of the indoor air to be recycled and determines the amount of humidity added to recycled air based on the temperature and absolute humidity of the introduced outside air while controlling the mixed quantity of the recycled air and outside air.

JP-2010-261696-A discloses a computer room air conditioner (CRAC) that has a filter, a cooling coil, and a supply fan disposed in that order from upstream to downstream, with a humidifier installed upstream or downstream of the cooling coil. The disclosed CRAC involves introducing outside air for air conditioning by the cooling coil or by the humidifier. If outside air has an atmosphere that fits the server room, the air is introduced unconditioned before being evacuated; the outside air is introduced unless it has a temperature lower than a predetermined level and an enthalpy higher than a predetermined value, or has a temperature higher than a predetermined level and an enthalpy higher than a predetermined value.

### SUMMARY OF THE INVENTION

The methods proposed by JP-2003-148782-A or JP-2010-261696-A cited above cannot solve the problems outlined below.

For example, if the humidity of outside air abruptly fluctuates during outside-air cooling, the fluctuation also causes the humidity of supply air fed from an air handling unit into the server room to change correspondingly.

Specifically, if a sudden downpour abruptly raises outside humidity, the humidity of supply air fed from the air handling unit into the server room also rises and may exceed an upper limit of the tolerable humidity range for the server room. When highly humid air is fed into the server room, circuit boards in the IT equipment may capture floating particles such as dust and sea salt particles as well as corrosive gases including sulfur dioxide gas and hydrogen sulfide gas in the air. Even if the relative humidity of the environment is below 100%, dew formation through chemical condensation may generate electrolyte solution that corrodes the circuit boards. Corroded circuit boards can seriously reduce the reliability of the IT equipment.

On the other hand, if outside humidity abruptly drops, the humidity of the supply air fed from the air handling unit into the server room also drops and may fall below a lower limit of the tolerable humidity range for the server room. If extremely dry outside air is fed into the server room, electrostatic discharges can develop over circuit boards inside the IT equipment, causing malfunction of the equipment.

Where outside temperature or humidity abruptly changes to a degree that triggers operation mode changeover of the currently operating air-side free cooling system, operation mode typically remains unchanged immediately after an operation mode boundary is exceeded. Generally, a certain time period following the breach of the operation mode boundary is set aside as an assessment time in which to determine whether or not to change the operation mode. Upon elapse of that assessment time, the operation mode may be changed as needed. The assessment time is established so as to reduce the instability of control over air conditioning operation during outside air fluctuation.

However, particularly when outside humidity fluctuates suddenly, very humid or very dry air is fed into the server room while the assessment time is allowed to expire. This will not provide a solution to the problem of lowered reliability as in the case of the method proposed by JP-2003-148782-A cited above.

The present invention has been made in view of the above circumstances and provides an air-side free cooling system and a data center equipped therewith, the air-side free cooling system being used in conjunction with an air conditioning system to perform control so that the humidity of supply air fed from an air handling unit (AHU) into the interior does not fluctuate abruptly even if outside temperature or humidity suddenly changes during air conditioning operation using outside air, whereby the indoor environment is optimized.

Present inventors invented a new air-side cooling system which could solve the above mentioned problems.

Present invention is an air-side cooling system, the system including: an air handling unit configured to be an air conditioner for getting outside air purified and adjusted in temperature and humidity before supplying the air into the interior; an air conveying duct configured to circulate outside air and return air from the interior; an outside air inlet configured to introduce outside air from the exterior; an air outlet configured to vent the air to the exterior; and a calculation and control unit configured to have a plurality of operation modes set beforehand in which to perform at least the mixing of outside air and return air or the dehumidification, humidification, or cooling of outside air in accordance with temperature and humidity conditions of outside air, the calculation and control unit further determining a operation mode in keeping with the temperature and humidity conditions of the outside air introduced through the outside air inlet; wherein the air-side free cooling system changes the operation mode determined by the calculation and control unit so that the supply air fed from the air handling unit into the interior is adjusted to a predetermined temperature and humidity; and wherein the calculation and control unit includes: a first function for setting an assessment time for operation mode changeover if a boundary of the current operation mode is exceeded due to fluctuating temperature or humidity conditions of the outside air introduced through the outside air inlet; a second function such that if the boundary of the current operation mode is exceeded due to the fluctuating temperature or humidity conditions of the outside air introduced through the outside air inlet, then the second function predicts the humidity of supply air fed from the air handling unit into the interior in the current operation mode on the basis of the temperature and humidity conditions of the outside air; and a third function such that if the boundary of the current operation mode is exceeded due to the fluctuating temperature or humidity conditions of the outside air introduced through the outside air inlet and if the supply air humidity predicted by the second function does not exceed an upper limit of a predetermined tolerable humidity range for the interior and does not fall below a lower limit thereof, then the third function changes the operation mode upon elapse of the assessment time, the third function further changing the operation mode immediately without waiting for the assessment time to expire if the supply air humidity predicted by the second function either exceeds the upper limit of the predetermined tolerable humidity range for the interior or falls below the lower limit thereof.

The present invention thus proposes an air-side free cooling system that utilizes outside air in winter and intermediate periods (spring and fall) even if the temperature or humidity of outside air abruptly fluctuates during outside-air cooling, the system prevents the humidity of supply air fed from the air handling unit into the interior from changing suddenly. This makes it possible to optimize the indoor environment during outside-air cooling.

### BRIEF DESCRIPTION OF THE DRAWINGS

Fig. 1 is a block flow diagram showing an air-side free cooling system according to the present invention applied to a data center;
Fig. 2 is a schematic diagram showing a functional structure of the air-side free cooling system according to the present invention;
Fig. 3 is an explanatory diagram showing how typical annual operation modes of the air-side free cooling system according to the present invention may be represented on a psychrometric chart;
Fig. 4 is an explanatory chart showing an operation flow of the air-side free cooling system according to the present invention;
Fig. 5 is an explanatory diagram showing how typical operation modes of the air-side free cooling system according to the present invention and operating when outside humidity abruptly fluctuates may be represented on a psychrometric chart;
Fig. 6 is a block flow diagram explaining a data center to which an air-side free cooling system of an ordinary structure is applied;
Fig. 7 is a psychrometric chart explaining an ordinary outside-air cooling method;
Fig. 8 is an explanatory diagram showing a typical history of humidity fluctuations in the supply air of the air-side free cooling system according to the present invention and operating when outside humidity rose abruptly;
Fig. 9 is an explanatory diagram showing a typical history of humidity fluctuations in the supply air of the air-side free cooling system according to the present invention and operating when outside humidity dropped abruptly; and
Fig. 10 is a block flow diagram showing how, in a data center to which the air-side free cooling system according to the present invention is applied, supply air from an air handling unit of the system may be fed directly into a server room by a lateral air supply method.

### DESCRIPTION OF THE PREFERRED EMBODIMENTS

The present invention is described below in detail by reference to the case in which the air-side free cooling system according to the present invention is applied to a data center.

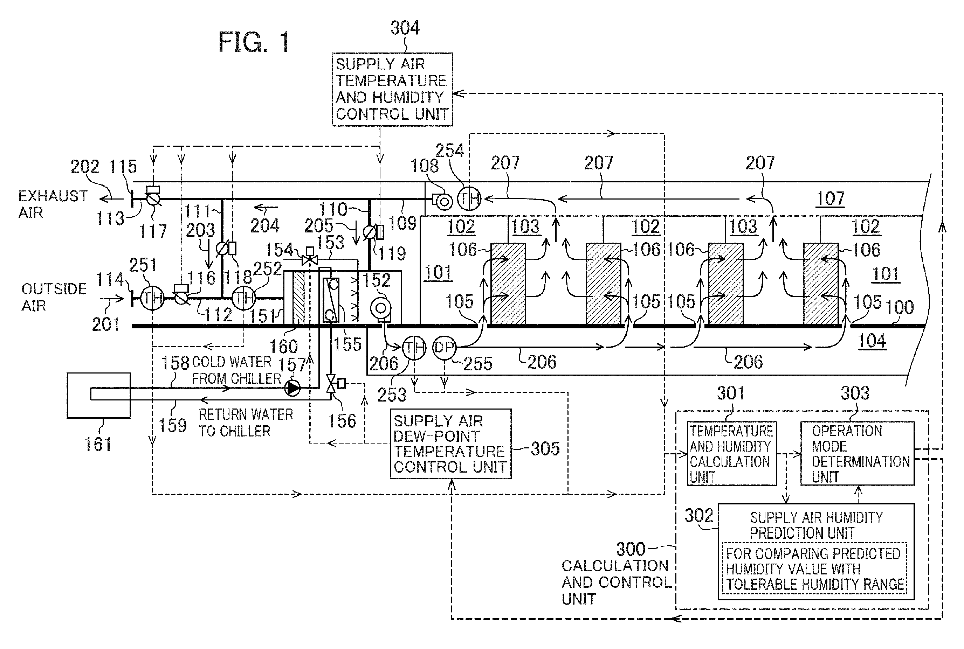

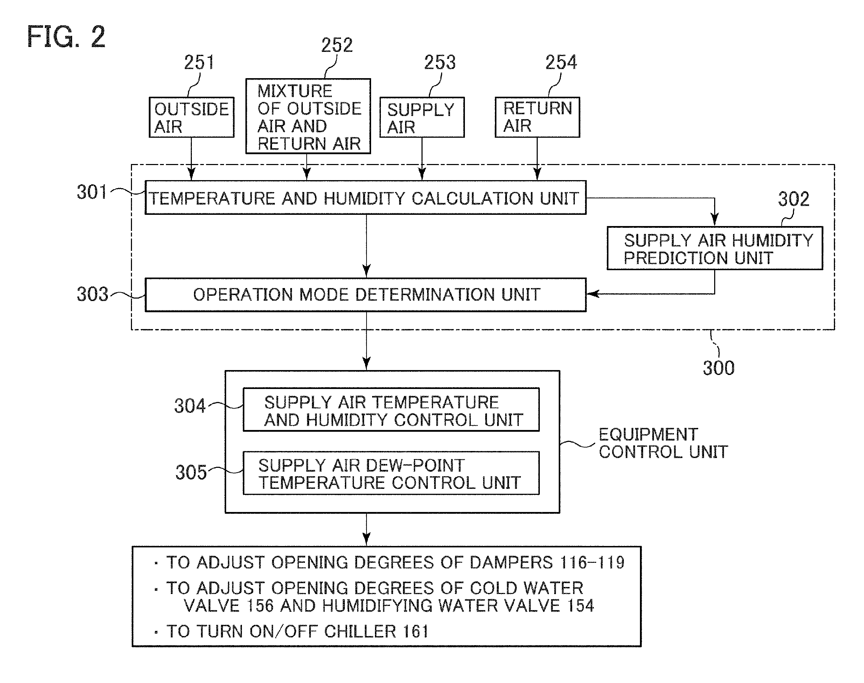

Fig. 1 is a block flow diagram showing the air-side free cooling system according to the present invention applied to a data center. Fig. 2 is a schematic diagram showing a functional structure of the air-side free cooling system according to the invention.

The equipment of the system is configured to include an air handling unit 151 as an air conditioner that has outside air 201 purified and adjusted in temperature and humidity before feeding the adjusted cool air (supply air 206) to a server room 101; air conveying ducts 109 - 113 that circulate the outside air 201 and return air 207 from IT equipment mounted on ICT racks 106 in the server room 101; an outside air inlet 114 that introduces the outside air 201 from the exterior; an air outlet 115 that vents the return air 207 to the exterior as exhaust air 202; and a chiller 161 and a cold water pump 157 for supplying cold water 158 to the air handling unit 151. The air handling unit 151 contains a dust filter 160, a cooling coil (heat exchanger) 155, a water vaporization humidifier 153, and a supply fan 152.

The cool air (supply air 206) from the air handling unit 151 is allowed to flow into cold aisles 102 and to the IT equipment on the ICT racks 106 through an opening (grating) 105 of a floor 100 from under a double floor (free access) 104. Warm air from behind the IT equipment is evacuated from hot aisles 103 separated from the cold aisles 102 by a circulation fan 108. Where a plurality of ICT racks 106 are arrayed inside the server room 101, the cold aisles 102 and hot aisles 103 are alternated in layout to boost air conditioning efficiency; the cold aisles 102 constitute a cool air area in which the fronts of the ICT racks 106 (inlet side) are faced with one another, while the hot aisles 103 make up a warm air area in which the backs of the ICT racks 106 (exhaust side) are faced with one another.

The air conveying ducts 109 - 113 are equipped with dampers 116 - 119 for adjusting the flow rate of air circulation. A cold water valve 156 is provided to adjust the flow rate of cold water supplied to the cooling coil (heat exchanger) 155 inside the air handling unit 151. The water vaporization humidifier 153 is furnished with a humidifying water valve 154 for changing the flow rate of humidifying water.

Also, thermo-hygrometers 251 - 254 are installed between the outside air inlet 114 and the damper 116 (outside air position), on the inlet side of the air handling unit 151, on the outlet side of the air handling unit 151 (supply air position), and upstream of the circulation fan 108 (return air position). Furthermore, a dew point thermometer 255 is installed on the outlet side of the air handling unit 151 (supply air position).

A calculation and control unit 300 is made up of a temperature and humidity calculation unit 301, a supply air humidity prediction unit 302, and an operation mode determination unit 303.

With this embodiment, as shown in Fig. 2, a thermo-hygrometer 251 for outside air, a thermo-hygrometer 252 for measuring the temperature and humidity of the mixture of outside air and return air, a thermo-hygrometer 253 for supply air, and a thermo-hygrometer 254 for return air are used to measure the temperature and humidity values of the outside air 201, of the mixture of outside air and return air, of the supply air 206, and of the return air 207. The measurements are fed to the temperature and humidity calculation unit 301 in the calculation and control unit 300. In turn, the temperature and humidity calculation unit 301 calculates specific enthalpy values in addition to the temperature values (dry-bulb temperature, wet-bulb temperature, dew-point temperature) and humidity values (relative humidity, absolute humidity) of the air.

Based on the temperature and humidity values of outside air, supply air and return air and specific enthalpy calculated by the temperature and humidity calculation unit 301, the supply air humidity prediction unit 302 predicts the humidity of the supply air 206 in the operation mode in effect before the operation mode boundary is exceeded. If the humidity of the outside air 201 abruptly fluctuates, the supply air humidity prediction unit 302 determines whether the humidity of the supply air 206 will exceed the operation mode boundary during operation in the current operation mode using the outside air 201 with its humidity suddenly changed. Also, the supply air humidity prediction unit 302 sets an assessment time that is a predetermined time period within which to determine whether or not to change the operation mode after the operation mode boundary is exceed.

Based on the temperature and humidity values of outside air, supply air and return air and specific enthalpy obtained by the temperature and humidity calculation unit 301 and on the predicted humidity of supply air acquired by the supply air humidity prediction unit 302, the operation mode determination unit 303 performs the determination as follows: if the predicted value does not exceed the upper limit of a predetermined tolerable humidity range inside the server room 101 and does not fall below the lower limit thereof and if, upon elapse of the assessment time, an operation mode suitable for the changed humidity conditions is maintained, the operation mode determination unit 303 determines that the operation mode suitable for the changed humidity conditions be selected. If the operation mode in effect before the operation mode boundary was exceeded is resumed at least once during the assessment time, then the operation mode determination unit 303 determines that the operation mode in effect before the operation mode boundary was exceeded be continued without changing the operation mode. If the predicted value exceeds the upper limit of the predetermined tolerable humidity range inside the server room 101 or falls below the lower limit thereof, the operation mode determination unit 303 determines that the operation mode be immediately changed without waiting for the assessment time to expire. The operation mode to be selected upon determination is the most optimal of a plurality of predetermined operation modes that allows the supply air fed into the server room 101 to have predetermined temperature and humidity values.

Thereafter, the result of the determination is transmitted to a supply air temperature and humidity control unit 304 and a supply air dew-point temperature control unit 305. In turn, the units adjust the opening degrees of the dampers 116 - 119, cold water valve 156, and humidifying water valve 154 in such a manner that the supply air 206 will attain predetermined temperature and humidity settings.

With this embodiment, the temperature and humidity calculation unit 301, supply air humidity prediction unit 302, and operation mode determination unit 303 constitute the calculation and control unit 300. Also, the supply air humidity prediction unit 302 has a first and a second function, and the operation mode determination unit 303 has a third function. The supply air temperature and humidity control unit 304 and supply air dew-point temperature control unit 305 are tasked with adjusting the supply air fed into the server room to predetermined temperature and humidity values. However, these arrangements are only examples and not limitative of the present invention.

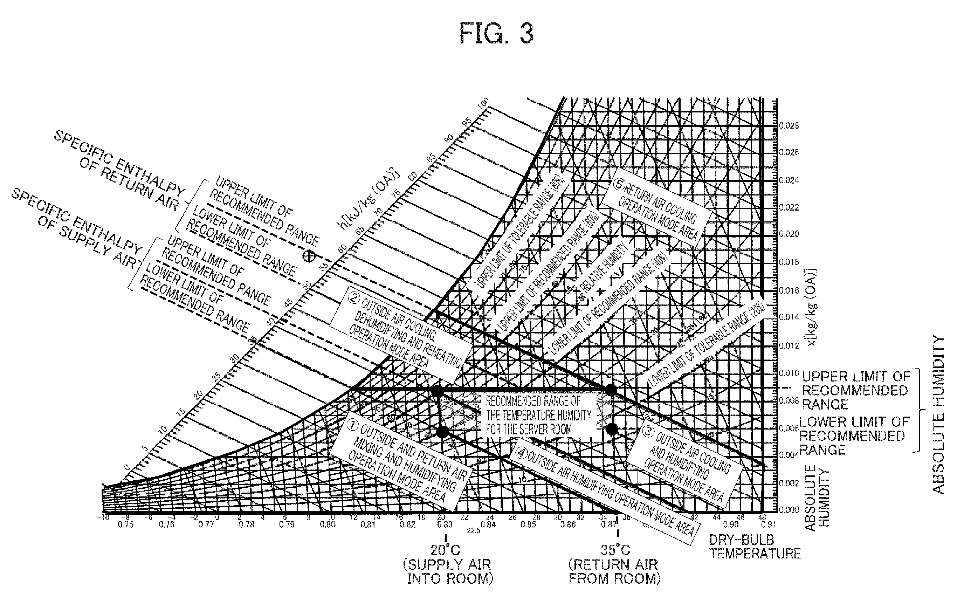

What follows is an explanation of the operation modes involved. Fig. 3 is an explanatory diagram showing how typical annual operation modes may be represented on a psychrometric chart.

The explanatory diagram was prepared on the assumption that the dry-bulb temperature of the supply air 206 into the server room 101 is 20°C, that the recommended relative humidity range of the supply air 206 is between 40% (lower limit) and 60% (upper limit), and that the dry-bulb temperature of the return air 207 from the server room 101 is 35°C. Depending on where the temperature and humidity conditions of the outside air 201 are located on the psychrometric chart, the operation modes are roughly classified into the following five categories (1) - (5):

### (1) Outside and return air mixing and humidifying operation mode

Mode (1) is an operation mode selected if the dry-bulb temperature of the outside air 201 is lower than the dry-bulb temperature of 20°C of the supply air 206 and if the absolute humidity of the outside air 201 is higher than the lower limit of the absolute humidity of the supply air 206 (equivalent to 40% in relative humidity) and lower than the upper limit of the absolute humidity (equivalent to 60% in relative humidity) thereof; or if the specific enthalpy of the outside air is lower than the lower limit of the recommended specific enthalpy range of the supply air 206 and if the absolute humidity of the outside air 201 is lower than the lower limit of the absolute humidity of the supply air 206 (equivalent to 40% in relative humidity).

Where the dry-bulb temperature of the outside air 201 is lower than the dry-bulb temperature of 20°C of the supply air 206 and where the absolute humidity of the outside air 201 is higher than the lower limit of the absolute humidity of the supply air 206 (equivalent to 40% in relative humidity) and lower than the upper limit of the absolute humidity (equivalent to 60% in relative humidity) thereof, the outside air 201 and return air 207 are mixed in such a manner as to adjust the supply air 206 to desired temperature and humidity conditions. In this case, the dampers 116, 117 and 118 are opened and the damper 119 is closed to mix the outside air 201 and return air 203. The mixed air is fed as is into the server room 101 by the supply fan 152 in the air handling unit 151. At this time, the chiller 161 and humidifier 153 are left inactive.

Where the specific enthalpy of the outside air 201 is lower than the lower limit of the recommended specific enthalpy range of the supply air 206 and where the absolute humidity of the outside air 201 is lower than the lower limit of the absolute humidity of the supply air 206 (equivalent to 40% in relative humidity), the humidifier 153 is operated after the mixture of the outside air 201 and return air 203 to adjust the supply air 206 to desired temperature and humidity conditions. In this case, the dampers 116, 117 and 118 are opened and the damper 119 is closed to mix the outside air 201 and return air 203. The mixed air is humidified by the humidifier 153 in the air handling unit 151 before being fed into the server room 101 by the supply fan 152. At this time, the chiller 161 is left inactive.

### (2) Outside air cooling, dehumidifying and reheating operation mode

Mode (2) is an operation mode selected if the specific enthalpy of the outside air 201 is lower than the upper limit of the recommended specific enthalpy range for the return air 207 and if the absolute humidity of the outside air 201 is higher than the upper limit of the absolute humidity of the supply air 206 (equivalent to 60% in relative humidity).

In this case, the dampers 116, 117 and 119 are opened and the damper 118 is closed. The outside air 201 is dehumidified and cooled through cold condensation by the cooling coil (heat exchanger) 155 in the air handling unit 151 until the absolute humidity of the dehumidified air becomes equal to the upper limit of the absolute humidity of the supply air 206. Thereafter, the cooled outside air and the return air 205 are mixed for reheating, with the supply fan 152 feeding into the server room 101 the supply air 206 adjusted to desired temperature and humidity conditions.

### (3) Outside air cooling and humidifying operation mode

Mode (3) is an operation mode selected if the specific enthalpy of the outside air 201 is higher than the upper limit of the recommended specific enthalpy range for the supply air 206 and lower than the upper limit of the recommended specific enthalpy range for the return air 207 and if the absolute humidity of the outside air 201 is lower than the upper limit of the absolute humidity of the supply air 206.

In this case, the dampers 116 and 117 are opened and the dampers 118 and 119 are closed. The outside air 201 is cooled by the cooling coil (heat exchanger) 155 in the air handling unit 151 before being humidified by the humidifier 153. The supply fan 152 feeds into the server room 101 the supply air 206 adjusted to desired temperature and humidity conditions.

### (4) Outside air humidifying operation mode

Mode selected if the specific enthalpy of the outside air 201 is higher than the lower limit of the recommended specific enthalpy range for the supply air 206 and lower than the upper limit thereof and if the dry-bulb temperature of the outside air 201 is higher than the dry-bulb temperature of the supply air 206.

In this case, the dampers 116 and 117 are opened and the dampers 118 and 119 are closed. The outside air 201 is humidified by the humidifier 153 in the air handling unit 151. After humidification, the supply fan 152 feeds into the server room 101 the supply air 206 adjusted to desired temperature and humidity conditions. At this time, the chiller 161 is left inactive.

### (5) Return air cooling operation mode

Mode selected if the specific enthalpy of the outside air 201 is higher than the upper limit of the recommended specific enthalpy range for the return air 207.

In this case, only the damper 118 is opened and the dampers 116, 117 and 119 are closed. No outside air 201 is introduced. All return air 207 is cooled by the cooling coil (heat exchanger) 155 in the air handling unit 151. After cooling, the supply fan 152 feeds into the server room 101 the supply air 206 adjusted to desired temperature and humidity conditions.

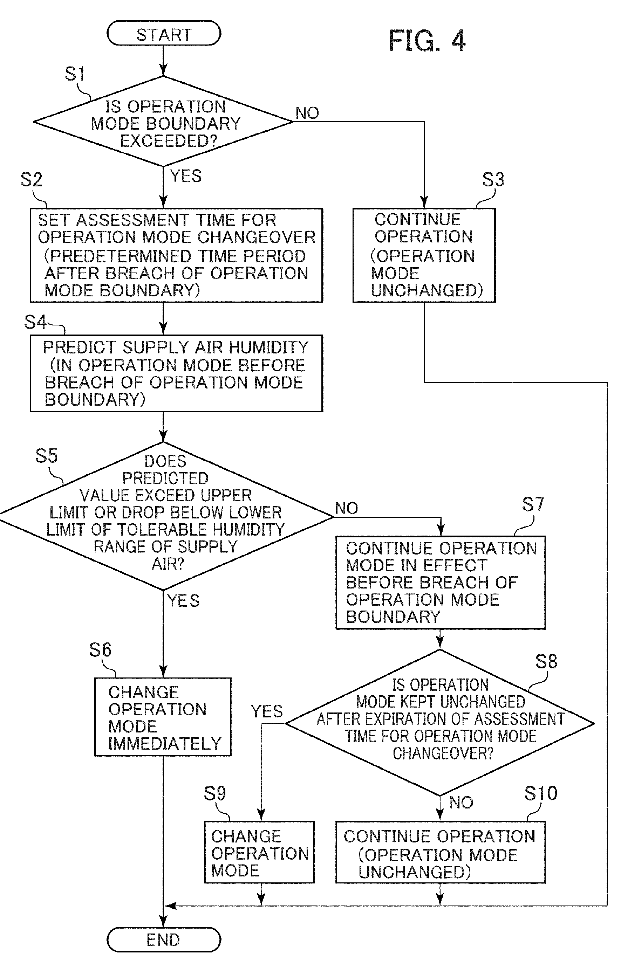

Explained below in reference to the operation flow in Fig. 4 is how operations are carried out when the humidity of the outside air 201 abruptly fluctuates.

If the humidity of the outside air 201 suddenly changes, the supply air humidity prediction unit 302 in the calculation and control unit 300 determines whether an operation mode boundary is exceeded (step S1).

If it is determined in step S1 that the operation mode boundary is exceeded, step S2 is reached. In step S2, immediately after the operation mode boundary is exceeded, the supply air humidity prediction unit 302 does not change the current operation mode and sets an assessment time as a predetermined time period within which to determine whether or not to change the operation mode (step S2). From step S2, control is passed on to step S4. If the operation mode boundary is not exceeded, the current operation mode is left unchanged and the operation is continued (step S3).

Thereafter, the supply air humidity prediction unit 302 predicts what the humidity of the supply air 206 will be like if the operation is continued in the operation mode in effect before the operation mode boundary was exceeded (step S4).

Later, the operation mode determination unit 303 determines whether the predicted humidity value exceeds the upper limit of a predetermined tolerable humidity range of the supply air 206 or falls below the lower limit thereof (step S5).

If the predicted humidity value of the supply air 206 exceeds the upper limit of the tolerable humidity range of the supply air 206 or falls below the lower limit thereof, the operation mode determination unit 303 transmits the result of the determination to the supply air temperature and humidity control unit 304 and supply air dew-point temperature control unit 305. In turn, these units adjust the opening degrees of the dampers 116 - 119, cold water valve 156 and humidifying water valve 154 immediately to change the operation mode (step S6). If the predicted value does not exceed the upper limit of the tolerable humidity range and does not fall below the lower limit thereof, the operation mode determination unit 303 continues the operation mode in effect before the operation mode boundary was exceeded and keeps counting the assessment time (step S7).

After the assessment time for determining whether or not to change the operation mode has expired, the operation mode determination unit 303 determines whether the operation mode suitable for the conditions following the humidity change is maintained after the operation mode boundary was exceeded without resumption even once of the operation mode in effect before the operation mode boundary was exceeded (step S8).

If the operation mode suitable for the conditions following the humidity change is maintained, the operation mode determination unit 303 changes to that operation mode suitable for the conditions subsequent to the humidity change (step S9). If the operation mode in effect before the operation mode boundary was exceeded was resumed even once, the operation mode determination unit 303 determines that the humidity of outside air still fluctuates wildly without being stabilized and that the operation mode in effect before the operation mode boundary was exceeded be continued without changing the operation mode (step S10).

After step S3, S6, S9 or S10, control is returned to the beginning of the operation flow and the above-described steps are repeated.

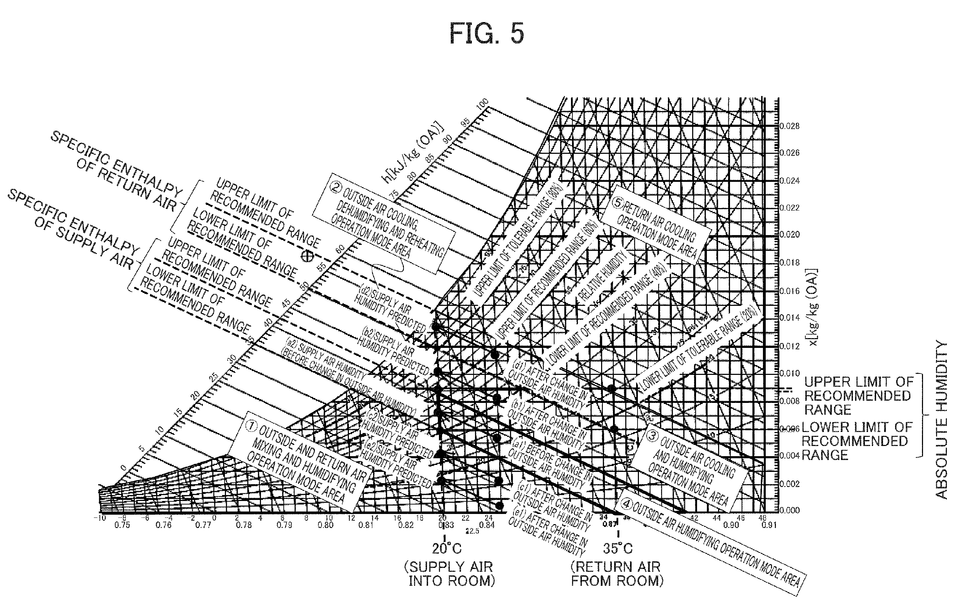

Fig. 5 explains how the above-described operation modes are typically represented on a psychrometric chart. In Fig. 5, reference character (a1) denotes the condition in effect before the humidity of the outside air 201 abruptly changes. Because the chart area designated by this condition applies to the outside air humidifying operation mode (4) above, the condition (humidity) of the supply air 206 during operation in the outside air humidifying operation mode (4) is as denoted by reference character (a2) provided the dry-bulb temperature is 20°C.

At this point, if reference character (b1) or (c1) is assumed to designate the condition in effect after the boundary of the operation mode (outside air humidifying operation mode (4)) is exceeded due to the humidity fluctuation of the outside air 201, the predicted humidity of the supply air 206 during operation in the operation mode (outside air humidifying operation mode (4)) in effect before the operation mode boundary is exceeded is as denoted by reference character (b2) or (c2), respectively.

If it is assumed here that the upper limit and lower limit of a predetermined tolerable range of relative humidity of the supply air 206 are 80% and 20%, respectively, neither value (b2) nor value (c2) exceeds the tolerable humidity range. Thus if the condition of the outside air is as designated by reference character (b1) or (c1) upon elapse of the assessment time for determining whether or not to change the operation mode, then the outside air humidifying operation mode (4) is changed to the outside air cooling and humidifying operation mode (3)(if the outside air changes from (a1) to (b1)) or to the outside and return air mixing and humidifying operation mode (1)(if the outside air changes from (a1) to (c1)).

If the humidity of the outside air 201 abruptly changes and if the condition in effect after the boundary of the operation mode (outside air humidifying operation mode (4)) is exceeded is as denoted by reference character (d1) or (e1), then the predicted humidity value of the supply air 206 in the operation mode before the boundary of the operation mode (outside air humidifying operation mode (4)) is exceeded is as represented by reference character (d2) or (e2), respectively.

If it is assumed here that the upper limit and lower limit of the tolerable range of relative humidity of the supply air 206 are 80% and 20%, respectively, values (d2) and (e2) both exceed the tolerable humidity range. In that case, the operation mode is changed immediately without waiting for the assessment time for operation mode changeover to expire. That is, if the humidity of the outside air 201 changes from (a1) to (d1), the outside air humidifying operation mode (4) is changed immediately to the outside air cooling, dehumidifying and reheating operation mode (2). If the humidity of the outside air 201 changes from (a1) to (e1), then the outside air humidifying operation mode (4) is changed immediately to the outside and return air mixing and humidifying operation mode (1).

The major effects of this embodiment stemming primarily from its characteristic structure are explained below in comparison with a typical air-side free cooling system of the ordinary structure.

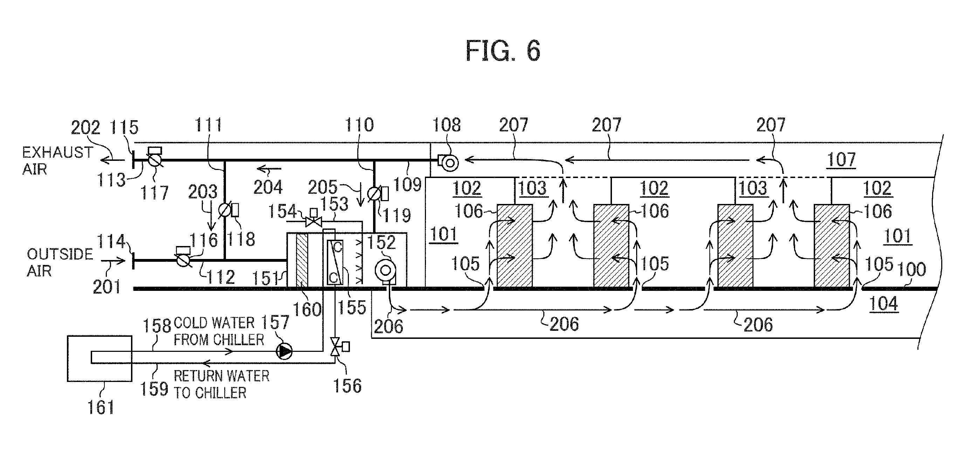

Fig. 6 is a block flow diagram explaining an air-side free cooling system of an ordinary structure.

The equipment of the system is configured to include an air handling unit 151 as an air conditioner that has outside air 201 purified and adjusted in temperature and humidity before feeding the adjusted cool air (supply air 206) to a server room 101; air conveying ducts 109 - 113 that circulate the outside air 201 and return air 207 from IT equipment mounted on ICT racks 106 in the server room 101; an outside air inlet 114 that introduces the outside air 201 from the exterior; an air outlet 115 that vents the return air 207 to the exterior as exhaust air 202; and a chiller 161 and a cold water pump 157 for supplying cold water 158 to the air handling unit 151. The air handling unit 151 contains a dust filter 160, a cooling coil (heat exchanger) 155, a water vaporization humidifier 153, and a supply fan 152. Sensors such as thermometers and hygrometers are not shown.

The cool air (supply air 206) from the air handling unit 151 is allowed to flow into cold aisles 102 and to the IT equipment on the ICT racks 106 through an opening (grating) 105 of a floor 100 from under a double floor (free access) 104. Warm air from behind the IT equipment is evacuated from hot aisles 103 separated from the cold aisles 102 by a circulation fan 108. Where a plurality of ICT racks 106 are arrayed in a data center of this ordinary structure, the cold aisles 102 and hot aisles 103 are alternated in layout to boost air conditioning efficiency; the cold aisles 102 constitute a cool air area in which the fronts of the ICT racks 106 (inlet side) are faced with one another, while the hot aisles 103 make up a warm air area in which the backs of the ICT racks 106 (exhaust side) are faced with one another.

With the air-side free cooling system of the above-described structure, the dampers 116 - 119 in the air conveying ducts are operated to mix the cool outside air 201 and hot return air 207 by adjusting their air flow rates in winter, for example. The humidifier 153 further humidifies the mixed air to control it to predetermined conditions (temperature and humidity) of the supply air 206 fed into the server room 101. At this time, there is no need to operate the chiller 161, so that only the supply fan 152 and circulation fan 108 consume the electric power for air conditioning purposes (i.e., power to convey air). The operating stages so far of this ordinary air-side free cooling system are approximately the same as those of the air-side free cooling system according to the present invention.

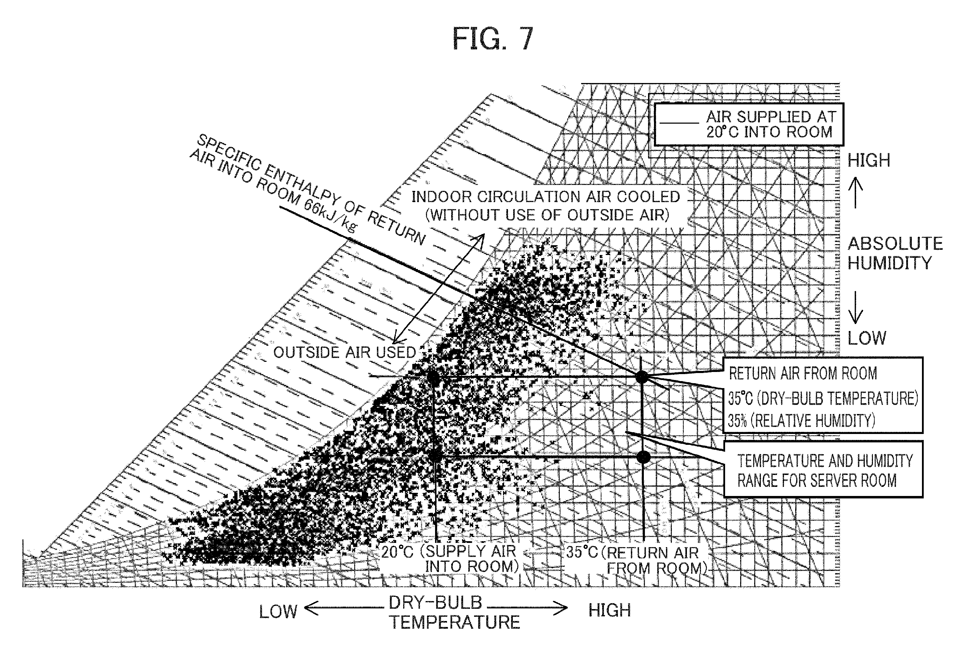

Fig. 7 is a psychrometric chart explaining an ordinary outside-air cooling method. Plotted on the psychrometric chart in Fig. 7 are the temperature and humidity conditions of Tokyo for 8,760 hours making up one year.

Suppose that the dry-bulb temperature of the supply air 206 (in the cold aisles 102) fed from the air handling unit 151 into the server room 101 is 20°C, that the dry-bulb temperature of the return air 207 (in the hot aisles 103) from inside the server room 101 is 35°C, and that the relative humidity of the return air 207 is 35% (shown framed in Fig. 7). In that case, the specific enthalpy of the return air 207 from the server room 101 is about 66 kJ/kg. Thus if the specific enthalpy of the outside air 201 is lower than the specific enthalpy of 66 kJ/kg of the return air 207 (e.g., in winter and intermediate periods), it is possible to utilize the outside air 201 effectively. In such a case, depending on the fluctuating temperature and humidity conditions of the outside air 201, operation modes are changed or combined automatically to mix the outside air 201 and return air 207 or to humidify, dehumidify and cool the outside air 201 suitably. The supply air 206 is thus adjusted to predetermined temperature and humidity conditions. In this manner, the outside air 201 is effectively utilized to alleviate the operation loads of the chiller 161. When the specific enthalpy of the outside air 201 is higher than that of the return air 207 (e.g., in summer), the outside air 201 is not introduced. Instead, all return air 207 is fed back to the air handling unit 151 and the chiller 161 is operated continuously to cool the return air 207.

With the air-side free cooling system of this ordinary structure, upon fluctuation of the temperature and/or humidity of outside air, the current operation mode is left unchanged immediately after an operation mode boundary is exceeded. A predetermined time period subsequent to the breach of the operation mode boundary is set as an assessment time in which to determine whether or not to change the operation mode. It is after the assessment time has expired that the operation mode is changed.

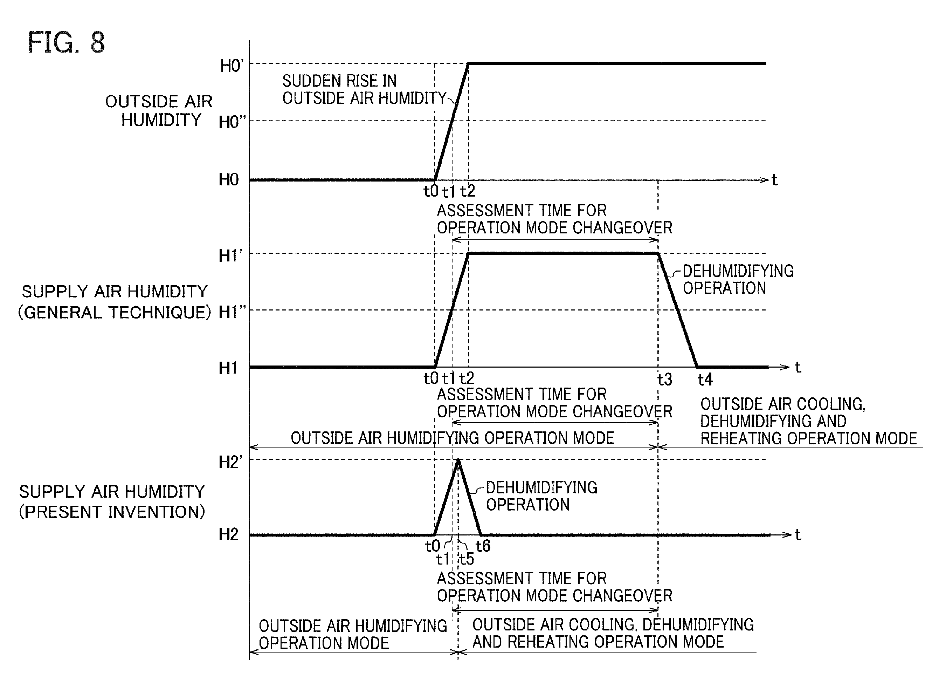

Fig. 8 shows a typical history of humidity fluctuations in the supply air 206 in effect when the humidity of the outside air 201 rose abruptly. As shown in the upper portion of Fig. 8, this is a case in which the humidity of the outside air 201 remains unchanged at H0 until time t0 and rises abruptly from H0 to H0' between time t0 and time t1. This phenomenon is representative of what is indicated in Fig. 5 in which the humidity of the outside air 201 rises from (a1) to (d1). In this case, the outside air humidifying operation mode (4) initially in effect is changed to the outside air cooling, dehumidifying and reheating operation mode (2), with the outside air cooling and humidifying operation mode (3) skipped therebetween.

At this time, where the assessment time is set by the air-side free cooling system of the ordinary structure such as one shown in Figs. 6 and 7, the humidity of the supply air 206 rises from H1 to H1' between time t0 and time t1, as shown in the middle portion of Fig. 8. The boundary of the area of the outside air humidifying operation mode (4) is first exceeded. Then starting from time t1 when the boundary of the area of the outside air cooling and humidifying operation mode (3) is exceeded, the assessment time is started (and continues until time t3). In the meantime, the outside air humidifying operation mode (4) remains unchanged. Past time t3, the outside air humidifying operation mode (4) is changed to the outside air cooling, dehumidifying and reheating operation mode (2) and dehumidifying operation is started. In this case, the condition in which the supply air 206 is highly humid (humidity H1') is prolonged (between time 1 and time 3). This can let circuit boards in the IT equipment capture floating particles such as dust and sea salt particles as well as corrosive gases including sulfur dioxide gas and hydrogen sulfide gas in the outside air 201. The resulting dew formation through chemical condensation may generate electrolyte solution that corrodes the circuit boards. Corroded circuit boards can seriously reduce the reliability of the IT equipment.

By contrast, according to the air-side free cooling system according to present invention, as soon as the predicted humidity value of the supply air 206 reaches (at time t5) the upper limit of the tolerable humidity range of the supply air 206 (relative humidity of 80% in Fig. 5), the outside air humidifying operation mode (4) is changed to the outside air cooling, dehumidifying and reheating operation mode (2), as shown in the lower portion of Fig. 8. The mode changeover makes it possible to minimize the rise in the humidity of the supply air 206 (H2 to H2') while shortening the time period in which the supply air 206 is highly humid (between time t1 and time t6). This can suppress equipment malfunction attributable to the corrosion of circuit boards in the IT equipment.

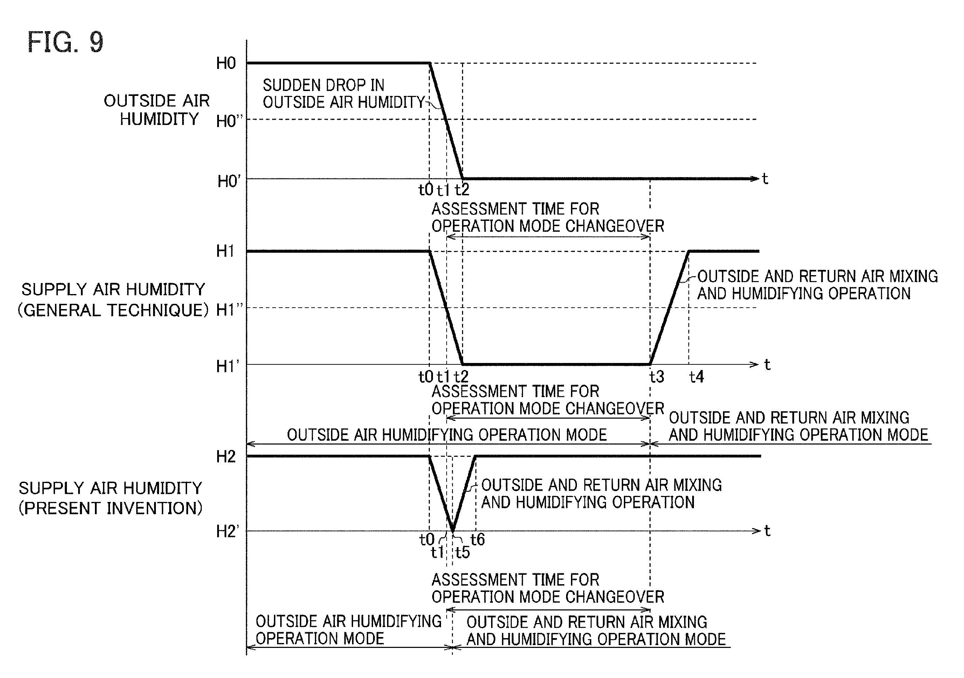

Fig. 9 shows a typical history of humidity fluctuations in the supply air 206 in effect when the humidity of the outside air 201 dropped abruptly. As shown in the upper portion of Fig. 9, this is a case in which the humidity of the outside air 201 remains unchanged at H0 and drops abruptly from H0 to H0' between time t0 and time t2. This phenomenon is representative of what is indicated in Fig. 5 in which the humidity of the outside air 201 drops from (a1) to (e1). In this case, the outside air humidifying operation mode (4) is changed to the outside and return air mixing and humidifying operation mode (1).

At this time, where the assessment time is set by the air-side free cooling system of the ordinary structure shown in Figs. 6 and 7, the humidity of the supply air 206 drops from H1 to H1' between time t0 and time t2, as shown in the middle portion of Fig. 9. Starting from time t1 at which the boundary of the area of the outside air humidifying operation mode (4) is exceeded and the boundary of the area of the outside and return air mixing and humidifying operation mode (1) is also exceeded, the assessment time for operation mode changeover is started (and continues until t3). In the meantime, the outside air humidifying operation mode (4) remains unchanged. Past time t3, the outside air humidifying operation mode (4) is changed to the outside and return air mixing and humidifying operation mode (1). In this case, the condition in which the supply air 206 is highly dehumidified (humidity H1') is prolonged (between time 1 and time 3). This can result in electrostatic discharges developing over circuit boards inside the IT equipment, causing malfunction of the IT equipment.

By contrast, according to the air-side free cooling system according to present invention, as soon as the predicted humidity value of the supply air 206 reaches (at time t5) the lower limit of the tolerable humidity range of the supply air 206 (relative humidity of 20% in Fig. 5), the outside air humidifying operation mode (4) is changed to the outside and return air mixing and humidifying operation mode (1), as shown in the lower portion of Fig. 9. The mode changeover makes it possible to minimize the drop in the humidity of the supply air 206 (H2 to H2') while shortening the time period in which the supply air 206 is highly dehumidified (between time t1 and time t6). This can inhibit electrostatic discharges developing over circuit boards inside the IT equipment thereby preventing malfunction of the IT equipment.

According to the preferred embodiment of the present invention explained above, when the humidity of the outside air 201 abruptly changes (a rise or a drop) during outside-air cooling operation at a data center subject to high heat loads requiring air conditioning throughout the year, it is possible to prevent the humidity of the supply air 206 fed from the air handling unit 151 into the server room 101 from fluctuating correspondingly. This protects the IT equipment against failure or malfunction attributable to corrosion or electrostatic discharges over circuit boards during outside-air cooling operation. That in turn strongly suppresses potential conditions that can seriously worsen the reliability of the IT equipment, whereby an optimal environment may be implemented for the data center.

In feeding cool air (supply air 206) into the server room 101, the air handling unit 151 may adopt not only the cold water method in which cold water 158 is supplied from the chiller 161 to the air handling unit 151, but also the direct expansion method in which the latent heat of vaporization of a fluorocarbon refrigerant is utilized for cooling the air.

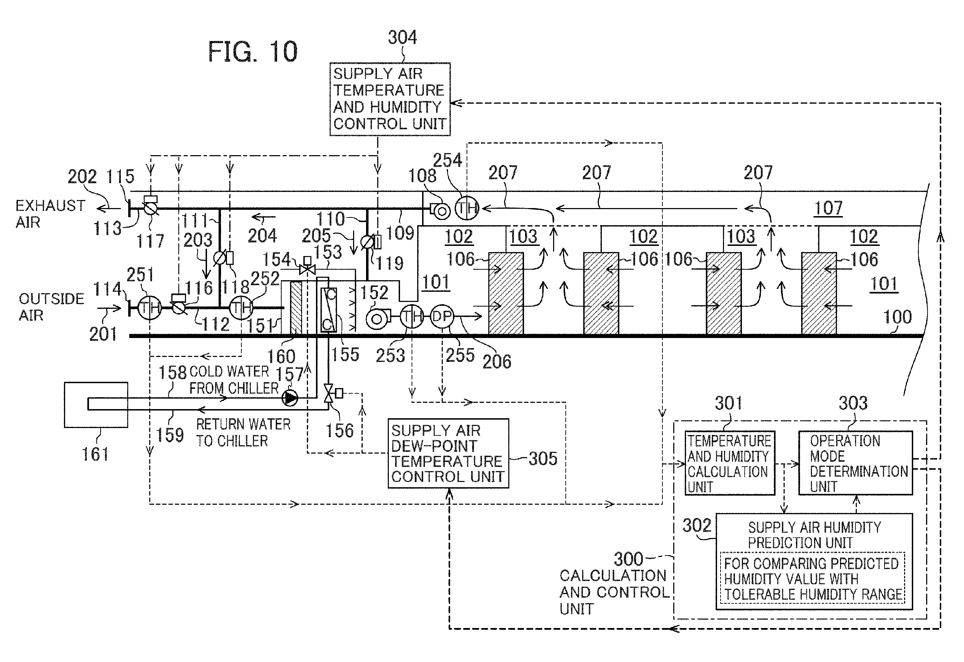

Also, it is possible to adopt not only the under-floor air supply method in which the supply air 206 fed by the air handling unit 151 is supplied from under the double floor 104 into the room as shown in Fig. 1, but also the lateral air supply method in which the air from the air handling unit 151 is fed directly into the server room 101 as shown in Fig. 10.

In a data center adopting the air-side free cooling system based on the lateral air supply method as shown in Fig. 10, the chilled air (supply air 206) fed from the air handling unit 151 is sent directly into the cold aisles 102 through the openings on the wall of the server room 101 and allowed to reach the IT equipment on the ICT racks 106. In this structure, the warm air from the back of the IT equipment is led into the hot aisles 103 separated from the cold aisles 102 before being evacuated by the circulation fan 108. The other structures are the same as those of the data center adopting the under-floor air supply method shown in Fig. 1 and thus will not be discussed further.

In the data center utilizing the lateral air supply method, as with the to the under-floor air supply method, it is also possible to suppress abrupt changes in the humidity of the supply air 206 when the humidity of the outside air 201 suddenly fluctuates.

The air-side free cooling system according to present invention applies not only to data centers but also to the air conditioners of factories, manufacturing sites and other environments subject to high heat loads, as well as to the air conditioners of offices, schools, and other public facilities.

Where the air-side free cooling system of the present invention is applied to the air conditioning systems of factories, manufacturing sites, offices and schools, abrupt changes in the humidity of the supply air fed to the factory compounds, manufacturing environments, and office interior are inhibited. This makes it possible to enhance the comfort of the interior and thereby help improve workability and productivity while maintaining the soundness of the facilities and equipment inside.

The above embodiments of the invention as well as the appended claims and figures show multiple characterizing features of the invention in specific combinations. The skilled person will easily be able to consider further combinations or sub-combinations of these features in order to adapt the invention as defined in the claims to his specific needs.

## Claims

1. An air-side free cooling system comprising:
an air handling unit configured to be an air conditioner for getting outside air purified and adjusted in temperature and humidity before supplying the air into the interior;
an air conveying duct configured to circulate outside air and return air from the interior;
an outside air inlet configured to introduce outside air from the exterior;
an air outlet configured to vent the air to the exterior; and
a calculation and control unit configured to have a plurality of operation modes set beforehand in which to perform at least the mixing of outside air and return air or the dehumidification, humidification, or cooling of outside air in accordance with temperature and humidity conditions of outside air, the calculation and control unit further determining a operation mode in keeping with the temperature and humidity conditions of the outside air introduced through the outside air inlet;
wherein the air-side free cooling system changes the operation mode determined by the calculation and control unit so that the supply air fed from the air handling unit into the interior is adjusted to a predetermined temperature and humidity; and
wherein the calculation and control unit includes:
a first function for setting an assessment time for operation mode changeover if a boundary of the current operation mode is exceeded due to fluctuating temperature or humidity conditions of the outside air introduced through the outside air inlet;
a second function such that if the boundary of the current operation mode is exceeded due to the fluctuating temperature or humidity conditions of the outside air introduced through the outside air inlet, then the second function predicts the humidity of supply air fed from the air handling unit into the interior in the current operation mode on the basis of the temperature and humidity conditions of the outside air; and
a third function such that if the boundary of the current operation mode is exceeded due to the fluctuating temperature or humidity conditions of the outside air introduced through the outside air inlet and if the supply air humidity predicted by the second function does not exceed an upper limit of a predetermined tolerable humidity range for the interior and does not fall below a lower limit thereof, then the third function changes the operation mode upon elapse of the assessment time, the third function further changing the operation mode immediately without waiting for the assessment time to expire if the supply air humidity predicted by the second function either exceeds the upper limit of the predetermined tolerable humidity range for the interior or falls below the lower limit thereof.

2. The air-side free cooling system according to claim 1, wherein the supply air from the air handling unit is caused to flow into the interior from under a double floor thereof.

3. The air-side free cooling system according to claim 1, wherein the supply air from the air handling unit is caused to flow directly into the interior.

4. A data center equipping the air-side free cooling system according to any one of claims 1 to 3.
